# EUROPEAN PATENT APPLICATION

(11) **EP 2 003 702 A1**
(43) Date of publication of application: **17.12.2008**
(21) Application number: 07011584.5
(22) Date of filing: 13.06.2007
(51) Int. Cl.: H01L 33/00

(54) **Semiconductor light emitting device and method of fabricating the same**

(71) Applicant: High Power Optoelectronics Inc., Taichung county 428 (TW)
(72) Inventor:
(74) Representative: Patentanwaltskanzlei WILHELM & BECK

(57) **Abstract**

The present invention provides a flip chip semiconductor light-emittingdevice which includes a substrate and a semiconductor multi-layer structure. The semiconductor multi-layer structure has a first surface and a second surface in opposition to the first surface. The semiconductor multi-layer structure is bonded to the substrate by the first surface. In addition, the second surface has a plurality of convex. More particularly, the plurality of convex is arranged in a periodic structure.

## Description

### BACKGROUND OF THE INVENTION

### 1. Field of the invention

The present invention is related to a semiconductor light-emitting devic acid the method cf fabricating the same, and more particularly, to a flip-chip semiconductor light-emitting device and the method of fabricating the same.

### 2. Description of the prior art

Because of the advantages of long life span, light weight, low power consumption, and absence of mercury, semiconductor light-emitting device such as light-emitting diode (LED), has become an ideal light source, and it has been greatly developed. LED can be applied in many fields, including information, communication, consumer electronics, vehicles, traffic lights, billboards, and illumination market. The most popular fields include the communication industry, such as in the back light of cellular phones and the light of keypads; the vehicle industry, such as the signal lights and the dashboards of cars; and other illumination industries, such as in billboards and lightings.

To more widely apply LED in related fields, the illumination of LED has to be raised. As known in the art, there are two ways to raise the illumination of LED: (1) enhance the efficiency of LED, and (2) enhance the power of LED.

In regard to the efficiency of LED, it can be raised by enhancing the internal quantum efficiency or the external extraction efficiency. Moreover, the internal quantum efficiency means the electro-optical conversion efficiency when the semiconductor chip is provided with electricity. Recently, because of the change of chip material from GaP to AlGaInP with high illumination, the internal quantum efficiency can approximately achieve 100%.

However, the low external extraction efficiency still results in he final illumination of LED being lower than the conversion efficiency of the chip. Furthermore, the reason of the low external extraction efficiency is mainly referred to the total reflection between different media and the absorption of the construction materials. Additionally, according to Snell's Law, when light enters a medium with low reflective index from a medium with high reflective index, the total reflection phenomenon will occur at the interface of these two media; thus, the light cannot be guided out efficiently. Because LED has many layers with different reflective index, the light generated by the active layer will be reflected back to the inside of the chip when it passes through the multi-layer structure and the external package structure, and the illumination of the LED is reduced. Moreover, the substrate and package material of LED could absorb the light and reduce the external extraction efficiency of LED.

Accordingly, those skilled in the art strive to overcome the disadvantages described above, so as to enhance the external extraction efficiency. For example, the light-absorbing substrate can be removed by wafer bonding and substrate-removing technologies, and then flip-chip format is used to bond the LED to a transparent substrate or high-reflective layer, so as to enhance the extraction efficiency. However, in general, the structure of LED lacks a window layer with enough thickness, thus causing the total reflection on the surface of the LED to be more obvious and causing the external extraction efficiency to be reduced.

### SUMMARY OF THE INVENTION

Accordingly, a scope of the invention is to provide a semiconductor light-emitting device and the method of fabricating the same, and more particularly, the semiconductor light-emitting device is a flip-chip semiconductor light emitting device, which has a higher external extraction efficiency than conventional semiconductor light-emitting devices, so it can improve the disadvantages of the prior art described above.

According to a preferred embodiment of the present invention, the flip-chip semiconductor light-emitting device includes a substrate and a semiconductor multi-layer structure. The semiconductor multi-layer structure has a first surface and a second surface. Furthermore, the first surface of the semiconductor multi-layer structure is bonded to a surface of the substrate, and the second surface has a plurality of protrusions arranged periodically.

Additionally, the protrusions include a first protrusion and a second protrusion adjacent to the first protrusion, the first protrusion and the second protrusion both have a peak, and the second surface has a bottom between the first and second protrusions, wherein the ratio of the vertical distance between one of the peaks and the bottom and the horizontal distance between two peaks is in between 0.01 and 10.

Furthermore, another scope of the present invention is to provide a method for fabricating a flip-chip semiconductor light-emitting device. The method, in accordance with a preferred embodiment of the invention, includes the steps of: first, forming a semiconductor multi-layer structure on a first substrate. Subsequently, flip-chip format is used to bond the semiconductor multi-layer structure on a second substrate. Afterward, the first substrate is removed, so as to expose a first surface of the semiconductor multi-layer structure. Finally, a plurality of protrusions is formed and arranged periodically on the first surface. Moreover, the protrusions include a first protrusion and a second protrusion adjacent to the first protrusion; the first protrusion and the second protrusion both have a peak, and the second surface has a bottom, wherein the ratio of the vertical distance between one of the peaks and the bottom and the horizontal distance between the two peaks is in between 0.01 and 10.

According to another preferred embodiment of the invention, the method for fabricating a flip-chip semiconductor light-emitting device includes the steps of first, forming a semiconductor multi-layer structure on a growth substrate. Subsequently, the flip-chip format is used to bond the semiconductor multi-layer structure on, a supporting substrate. Afterward, the growth substrate is removed, so as to expose a temporary surface of the semiconductor multi-layer structure. Then, a window layer is formed, on the temporary surface of the semiconductor multi-layer structure, :md the window layer has a second surface. Finally, a plurality of protrusions, arranged periodically, are formed on the second surface. Moreover, the protrusions include a first protrusion and a second protrusion adjacent to the first protrusion; the first protrusion and the second protrusion both have a peak, and the second surface has a bottom, wherein the ratio of the vertical distance between one of the peaks and the bottom and the horizontal distance between the two peaks is in between 0.01 and 10.

The scope of the present invention will no doubt become obvious to those of ordinary skill in the art after reading the following detailed description of the preferred embodiment, which is illustrated in the various figures and drawings.

### BRIEF DESCRIPTION OF THE APPENDED DRAWINGS

FIG. 1 is a sectional view of a flip-chip semiconductor light-emitting device of an embodiment of the invention.
FIG. 2 is a sectional view of a flip-chip semiconductor light-emitting device of an embodiment of the invention.
FIG. 3 is a sectional view of the second surface of an embodiment as described.
FIG. 4 is a sectional view of the second surface of an embodiment of the invention.
FIG. 5 is a flow chart of the method for fabricating the flip-chip semiconductor light-emitting device of the invention.
FIG. 6 is a flow chart of the method for fabricating the flip-chip semiconductor light-emitting device of the invention.

### DETAILED DESCRIPTION OF THE INVENTION

The present invention provides a flip-chip semiconductor light-emitting device. The preferred embodiments are disclosed as below.

First of all, the term "flip-chip semiconductor light-emitting device" refers to a semiconductor light-emitting device as described in TW Patent Publication No. 251388, entitled "Bonding-type light-emitting diode die and method of making the same". Particularly, during the process for fabricating the semiconductor light-emitting device, a semiconductor multi-layer structure is grown on a first substrate, and the semiconductor multi-layer structure has an exposed first surface. Subsequently, the first substrate is removed or polished, and the first surface of the semiconductor multi-layer structure is bonded to a second substrate to obtain the flip-chip semiconductor light-emitting device.

Alternatively, we can bond the first surface of the flip-chip semiconductor light-emitting device to the second substrate first, and then remove or polish the first substrate, to obtain the flip-chip semiconductor light-emitting device.

In a preferred embodiment, the flip-chip semiconductor light-emitting device includes a substrate and a semiconductor multi-layer structure. The semiconductor multi-layer structure has a first surface and a second surface. Furthermore, The first surface of the semiconductor multi-layer structure is bonded to a surface of the substrate, and the second surface has a plurality of protrusions arranged periodically.

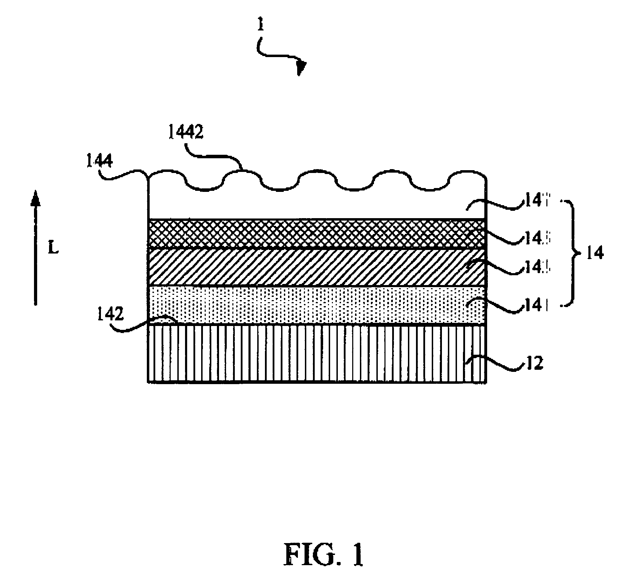

Please refer to FIG. 1, which is a sectional view of a flip-chip semiconductor light-emitting device of an embodiment of the invention. As shown in FIG 1, the flip-chip semiconductor light-emitting device 1 includes the substrate 12 and the semiconductor multi-layer structure 14. Moreover, the semiconductor multi-layer structure 14 has a first surface 142 and a second surface 144 opposite to the first surface 142. In addition, the first surface 142 of the semiconductor multi-layer structure 14 is bonded to a surface of the substrate 12, and the second surface 144 has a plurality of protrusions 1442. It should be noted that the plurality of protrusions 1442 of the embodiment are arranged periodically.

Also as shown in FIG. 1, the semiconductor multi-layer structure 14 further includes an active layer 145, a metal bonding layer 141, a reflecting layer 143, and a surface layer 147.

As shown in FIG. 1, the metal bonding layer 141 has the first surface 142; this is to say, the semiconductor multi-layer structure 14 is bonded to the substrate 12 by the metal bonding layer 141. Additionally, the reflecting layer 143 is located between the active layer 145 and the metal bonding layer 141, for reflecting the light generated by the active layer 145, so as to direct the light generated by the active layer 145 to be transmitted along a direction L. Furthermore, in the embodiment, the surface 147 has the second surface 144.

In practice, the vertical distance between the active layer and one protrusion of the second surface is in between 0.1 µm and 10 µm. In practice, the surface layer is formed by (AlₓGa₁₋ₓ)In_{1-y}P, such as n-type AIGaInP, p-type AlGaInP, or Al,Ga₁₋ₓAs, wherein 0≦x≦1, and 0≦y≦1.

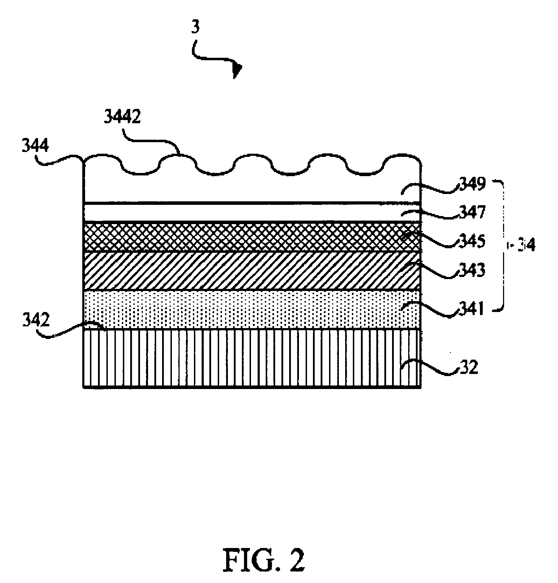

Please refer to FIG. 2, which is a sectional view of a flip-chip semiconductor light-emitting device of an embodiment of the invention. As shown in FIG. 2, the flip-chip semiconductor light-emitting device 3 also includes the substrate 32 and the semiconductor multi-layer structure 34. Moreover, the semiconductor multi-layer structure 34 also has a first surface 342 and a second surface 344 opposite tc the first surface 342. Additionally, the first surface 342 of the semiconductor multi-layer structure 34 is bonded to a surface of the substrate 32, and the second surface 344 has a plurality of protrusions 3442. Please note that, in the embodiment, the plurality of protrusions 3442 are arranged periodically.

Additionally, except the active layer 345, the metal bonding layer 341, the reflecting layer 343, and the surface layer 347, the semiconductor multi-layer structure 34 further includes a window layer 349. Moreover, in the embodiment, the window layer 349 is formed on the surface layer 347, and the window layer 349 has the second surface 344. In practice, the window layer can be formed by a conductive material, such as ITO, SiO₂, SiN, TiO₂, ZnO, and ZnSe.

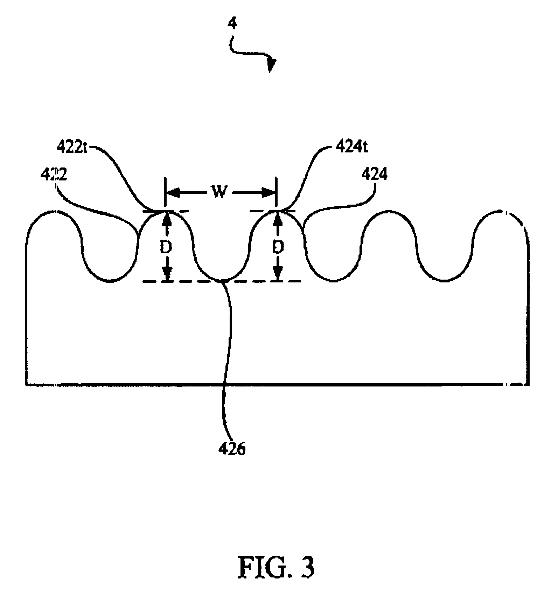

Please further refer to FIG. 3, which is a sectional view of the second surface of an embodiment as described above. As shown in FIG. 3, the plurality of protrusions 42 on the second surface 4 are arranged periodically. Particularly, the plurality of protrusions 42 contain a first protrusion 422 and a second protrusion 424 adjacent to the first protrusion 422, and both of the first protrusion 422 and the second protrusion 424 have a peak 422t and 424t respectively. Furthermore, the second surface 4 includes a bottom 426 between the first protrusion 422 and the second protrusion 424, and more particularly, the ratio of the vertical distance (D) between one of the peaks 422t, 424t and the bottom 426 and the horizontal distance (W) between the two peaks 422t, 424t is in between 0.01 and 10.

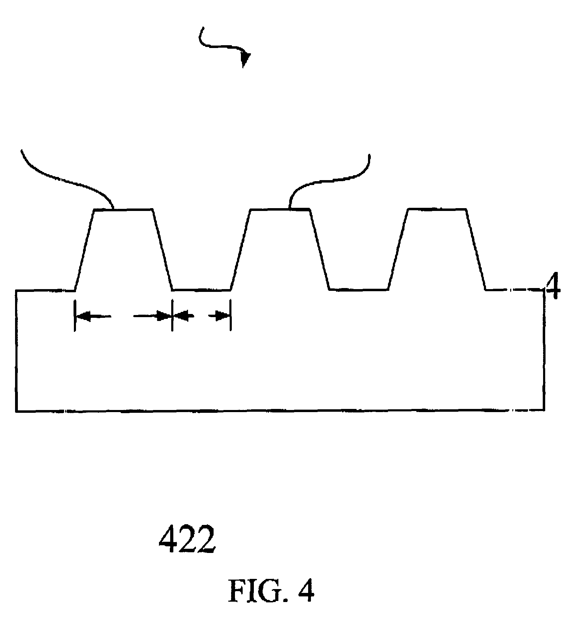

Please further refer to FIG. 4, which shows a sectional view of the second surface of another embodiment of the invention. Take the first protrusion 422 as an example, in the embodiment, a protrusion width M of each of the protrusions is in between 0.1 µm and 10 µm. Furthermore, take the first protrusion 422 and the second protrusion 424 as an example, in the embodiment, a protrusion distance N between the first protrusion 422 and the second protrusion 424 is in between 0.1µm and 10 µm.

Furthermore, in an embodiment, a protrusion area of the plurality of protrusions is 1-10 % of the total light-emitting area of the flip-chip semiconductor light emitting device.

According to a preferred embodiment of the invention, a method for fabricating a flip-chip semiconductor light-emitting device is provided.

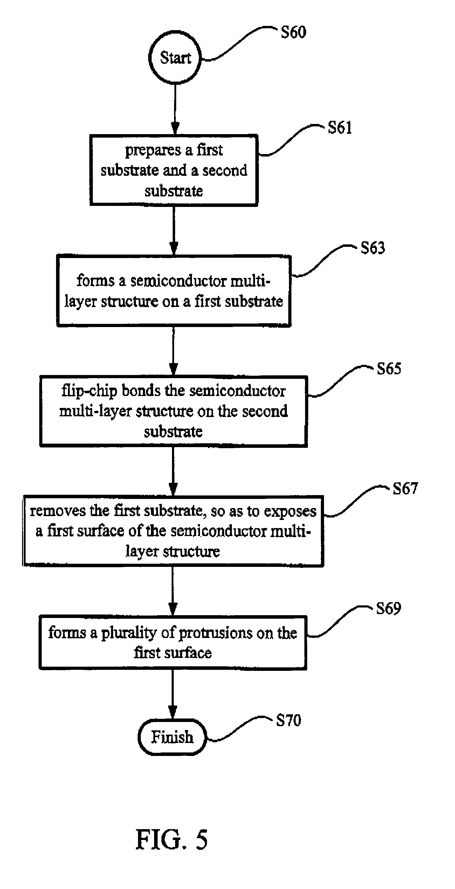

Please refer to FIG. 5, which is a flow chart of the method for fabricating the flip-chip semiconductor light-emitting device of the invention. As shown in FIG. 5, the method includes the following steps: first of all, preparing a first substrate and a second substrate (S61). Afterward, form a semiconductor multi-layer structure on a first substrate (S63). Subsequently, flip-chip format is used to bond the semiconductor multi-layer structure on the second substrate (S65). Afterward, remove the first substrate, so as to expose a first surface of the semiconductor multi-layer structure (S67). Finally, form a plurality of protrusions on the first surface (S69). Please note that, the plurality of protrusions are arranged periodically.

Furthermore, the protrusions include a first protrusion and a second protrusion adjacent to the first protrusion; the first protrusion and the second protrusion both have a peak, and the second surface has a bottom, wherein the ratio of the vertical distance between one of the peaks and the bottom and the horizontal distance between the two peaks is in between 0.01 and 10.

In practice, step S65 and step S67 can be optionally exchanged. Moreover, in practice, the plurality of protrusions in step S69 are formed by a photolithography process cooperated with an etching process. Furthermore, the etching process can be a wet etching process or a dry etching process. In practice, the semiconductor multi-layer structure is bonded to the second substrate by a metal bonding layer. In addition, practically, the semiconductor multi-layer structure can be bonded to the second substrate by a non-metal bonding layer or by providing high temperature and high pressure.

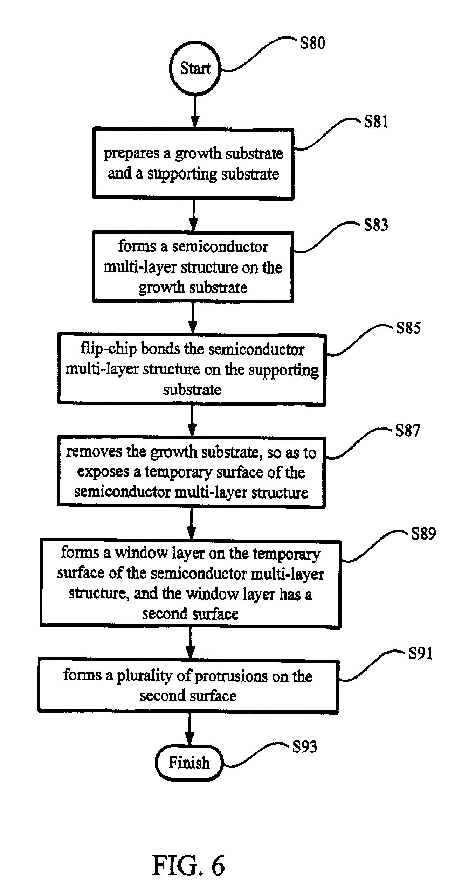

Please refer to FIG. 6, which is a flow chart of the method for fabricating the flip-chip semiconductor light-emitting device of the invention. As shown in FIG. 6, the method includes the steps of: first of all, preparing a growth substrate and a supporting substrate (S81). Afterward, form a semiconductor multi-layer structure on the growth substrate (S83). Then, flip-chip format is used to bond the semiconductor multi-layer structure on the supporting substrate (S85). Subsequently, remove the growth substrate, so as to expose a temporary surface of the semiconductor multi-layer structure (S87). Then, form a window layer on the temporary surface of the semiconductor multi-layer structure, and the window layer has a second surface (S89). Finally, form a plurality of protrusions on the second surface (S91). It should be noted that, the plurality of protrusions are arranged periodically.

Furthermore, the protrusions include a first protrusion and a second protrusion adjacent to the first protrusion; the first protrusion and the second protrusion both have a peak, and the second surface has a bottom, wherein the ratio of the vertical distance between one of the peaks and the bottom and the horizontal distance between the two peaks is in between 0.01 and 10.

In practice, step S85 and step S87 can be optionally exchanged. Moreover, in practice, the plurality of protrusions in step S91 are formed by a photolithography process cooperated with an etching process. Furthermore, the etching process can be a wet etching process or a dry etching process. In practice, the semiconductor multi-layer structure is bonded to the supporting substrate by a metal bonding layer. In addition, practically, the semiconductor multi-layer structure can be bonded to the supporting substrate by a non-metal bonding layer or by providing high temperature and high pressure.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. A flip-chip semiconductor light-emitting device, comprising:
a substrate; and
a semiconductor multi-layer structure having a first surface and a second surface in opposition to the first surface, the semiconductor multi-layer structure bonding to a surface of the substrate by the first surface, and the second surface having a plurality of protrusions arranged periodically;
wherein the protrusions comprise a first protrusion and a second protrusion adjacent to the first protrusion, the first protrusion and the second protrusion both having a peak, and the second surface having a bottom, wherein the ratio of the vertical distance between one of the peaks and the bottom and the horizontal distance between the two peaks is in between 0.01 and 10.

2. The flip-chip semiconductor light-emitting device of claim 1, wherein the semiconductor multi-layer structure comprises an active layer, and the vertical distance between the active layer and one protrusion of the second surface is in between 0.1 µm and 10 µm.

3. The flip-chip semiconductor light-emitting device of claim 2, wherein the semiconductor multi-layer structure comprises a metal bonding layer having the first surface.

4. The flip-chip semiconductor light-emitting device of claim 3, wherein the semiconductor multi-layer structure comprises a reflecting layer located between the active layer and the metal bonding layer, for reflecting the light generated by the active layer.

5. The flip-chip semiconductor light-emitting device of claim 1, wherein the semiconductor multi-layer structure comprises a surface layer having the second surface, and the surface layer being formed by (AlₓGa₁₋ₓ)_{y}In_{1-y}P or Al₂Ga₁₋ₓAs_{,}
wherein 0≦x≦1, and 0≦y≦ 1.

6. The flip-chip semiconductor light-emitting device of claim 1, wherein the semiconductor multi-layer structure comprises a surface layer and a window layer formed on the surface, and the window layer having the second surface.

7. The flip-chip semiconductor light-emitting device of claim 6, wherein the window layer is formed by a conductive material selected from the group consisting of: ITO, SiO₂, SiN, TiO₂, ZnO, and ZnSe.

8. The flip-chip semiconductor light-emitting device of claim 1, wherein the width of each of the protrusions is in between 0.1 µm and 10 µm, and a protrusion distance between the first protrusion and the second protrusion is in between 0.1 µm and 10 µm.

9. The flip-chip semiconductor light-emitting device of claim 1, wherein a protrusion area of the plurality of protrusions is 1-10 % of the total light emitting area of the flip-chip semiconductor light-emitting device.

10. A method for fabricating a flip-chip semiconductor light-emitting device, comprising the steps of:
(a) forming a semiconductor multi-layer structure on a first substrate;
(b) flip-chip bonding the semiconductor multi-layer structure on a second substrate;
(c) removing the first substrate, so as to expose a first surface of the semiconductor multi-layer structure; and
(d) forming a plurality of protrusions, arranged periodically, on the first surface;
wherein the protrusions comprise a first protrusion and a second protrusion adjacent to the first protrusion, the first protrusion and the second protrusion both having a peak, and the second surface having a bottom, wherein the ratio of the vertical distance between one of the peaks and the bottom and the horizontal distance between the two peaks is in between 0.01 and 10.

11. The method of claim 10, wherein the plurality of protrusions in step (d) are formed by a photolithography process cooperated with an etching process.

12. The method of claim 11, wherein the etching process is a wet etching process or a dry etching process.

13. The method of claim 10, wherein the semiconductor multi-layer structure in step (b) is bonded to the second substrate by a metal bonding layer.

14. The method of claim. 10, wherein the width of each of the protrusions is in between 0.1 µm and 10 µm, and a protrusion distance between the first protrusion and the second protrusion is in between 0.1 µm and 10 µm.

15. The method of claim 10, wherein a protrusion area of the plurality of protrusions is 1-10 % of the total light-emitting area of the flip-chip semiconductor light-emitting device.

16. A method for fabricating a flip-chip semiconductor light-emitting device, comprising the steps of:
(a) forming a semiconductor multi-layer structure on a growth substrate;
(b) flip-chip bonding the semiconductor multi-layer structure on a supporting substrate;
(c) removing the growth substrate, so as to expose a temporary surface of the semiconductor multi-layer structure;
(d) forming a window layer on the temporary surface of the semiconductor multi-layer structure, and the window layer having a second surface; and
(e) forming a plurality of protrusions, arranged periodically, on the second surface;
wherein the protrusions comprise a first protrusion and a second protrusion adjacent to the first protrusion, the first protrusion and the second protrusion both having a peak, and the second surface having a bottom, wherein the ratio of the vertical distance between one of the peaks and the bottom and the horizontal distance between the two peaks is in between 0.01 and 10.

17. The method of claim 16, wherein the plurality of protrusions in step (d) are formed by a photolithography process cooperated with an etching process

18. The method of claim 17, wherein the etching process is a wet etching process or a dry etching process.

19. The method of claim 16, wherein the semiconductor multi-layer structure in step (b) is bonded to the supporting substrate by a metal bonding layer.

20. The method of claim 16, wherein the width of each of the protrusions is in between 0.1 µm and 10 µm, and a protrusion distance between the first protrusion and the second protrusion is in between 0.1 µm and 10 µm.

21. The method of claim 16, wherein a protrusion area of the plurality of protrusions is 1-10 % of the total light-emitting area of the flip-chip semiconductor light-emitting device.
